Europäisches Patentamt

European Patent Office

Office européen des brevets

(11) Publication number: **0 174 710**
**A1**

(12) # EUROPEAN PATENT APPLICATION

(21) Application number: **85303243.1**

(22) Date of filing: **08.05.85**

(51) Int. Cl.⁴: **H 03 B 5/20**

(30) Priority: **11.08.84 GB 8420465**

(43) Date of publication of application:
**19.03.86 Bulletin 86/12**

(84) Designated Contracting States:
**DE FR GB NL**

(71) Applicant: **Cambridge Electronic Industries plc
P.O. Box 155 Botanic House 100, Hills Road
Cambridge CB2 1LQ(GB)**

(72) Inventor: **Eberhardt, Russell John
20 Toyse Lane
Burwell Cambridgeshire CB5 ODF(GB)**

(74) Representative: **Nash, Keith Wilfrid et al,
KEITH W. NASH & Co. Pearl Assurance House 90-92
Regent Street
Cambridge CB2 1DP(GB)**

(54) **Audio signal generator.**

(57) An audio signal generator incorporating a variable R.C. oscillator (10) wherein the basic timing capacitance is replaced by a capacitance multiplying circuit (12) in which a potentiometer is employed to impart frequency variations, the slider of this potentiometer being connected to one input of an operational amplifier.

The circuit has the advantage that a linear control scale is obtainable on which the frequency is independent of the absolute value of the control device.

EP 0 174 710 A1

Fig. 4

Title:    Audio Signal Generator

## Field of the Invention

This invention relates to an auio signal generator.

## Background to the invention

Audio signal generators commonly comprise an R.C oscillator to produce low distortion sine waves. Examples of such circuits are the Wien bridge type oscillator, the phase shift oscillator and the parallel-T oscillator. The frequency of oscillation for such an oscillator is given by the expression:

$f = \dfrac{K}{RC}$, where R and C are the frequency determining components and K is a constant which is fixed for a given type of oscillator.

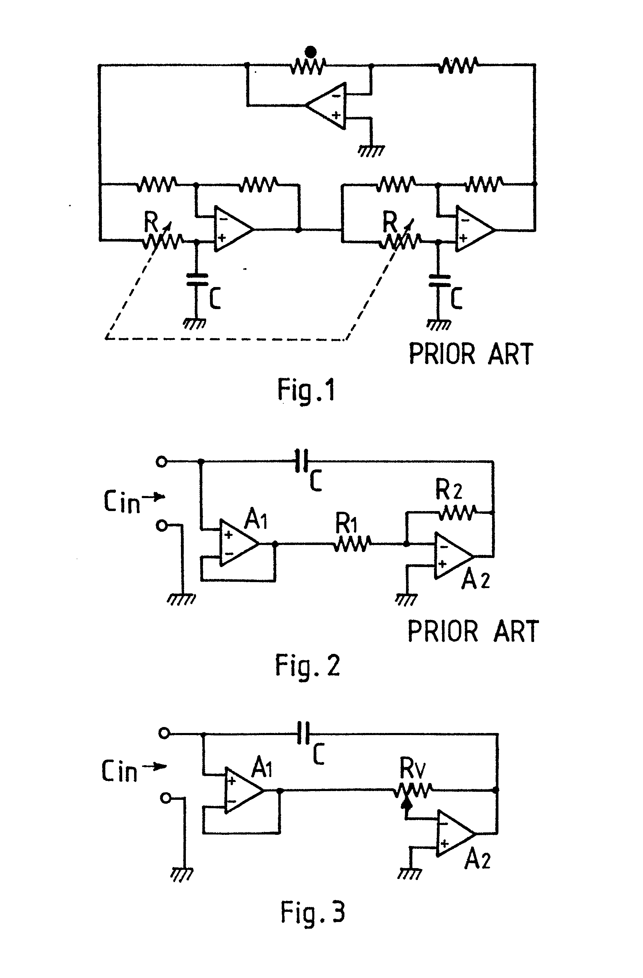

Frequency variation is enabled in a multiple section oscillator of this type by varying R or C using a two or three ganged control. An example of such a variable frequency audio signal generator is shown in Figure 1 of the accompanying drawings.

In such a variable frequency audio signal generator, the frequency scale is cramped at one end if a linear control is used. In addition, the frequency at any one point on the scale is dependent on the tolerance and the linearity of the control employed. Suitable control devices to minimise these disadvantages are available, but are inherently very expensive.

## Object of the invention

It is an object of this invention to provide a modified audio signal generator employing an R.C. oscillator, which avoids or minimises the above-described disadvantages without necessitating the use of expensive control devices.

## The invention

According to the invention, there is provided an audio signal generator of the type normally including at least one variable frequency oscillator providing for frequency variation by variation of the resistence or the capacitance in an R.C circuit, wherein the capacitance of said R.C. circuit is replaced by a capacitance multiplying circuit which, in order to provide for the generation of variable frequency signals, includes an amplified having an input connected to the tapping of a variable resistance connected in parallel with the basic capacitance of the multiplying circuit.

## Explanation

Figure 2 of the accompanying drawings shows one known form of a capacitance multiplying circuit, normally employed to increase the effective capacitance of a capacitor. The effective input capacitance of this circuit, $C_{in}$, is given by the expression:

$C_{in} = C(1 + \frac{R_2}{R_1})$, provided that the effects of finite gain in the operational amplifiers are ignored.

Figure 3 of the accompanying drawings shows a modified multiplying circuit having the property that the effective input capacitance $(C_{in})$ is inversely proportional to the position of the tapping of the variable resistance, ie in practice inversely proportional to the degree of angular rotation of a potentiometer $R_v$ assuming this to have a linear law, and independent of its absolute value.

As in the circuit of Figure 2, the operational amplified $A_1$ is not essential, but improves the Q factor of the effective capacitance.

The invention provides for the usual capacitor of the R.C. oscillator in an audio signal generating circuit such as that shown in Figure 1 to be replaced by a modified capacitance multiplying circuit as exemplified by Figure 3.

Description of the drawings

In the accompanying drawings:

Figure 1 shows the circuit of a known audio signal generator;
Figure 2 shows a known capacitance multiplying circuit;
Figure 3 shows a modified capacitance multiplying circuit; and
Figure 4 shows the circuit of an audio signal generator in accordance with the invention.

Description of the embodiment

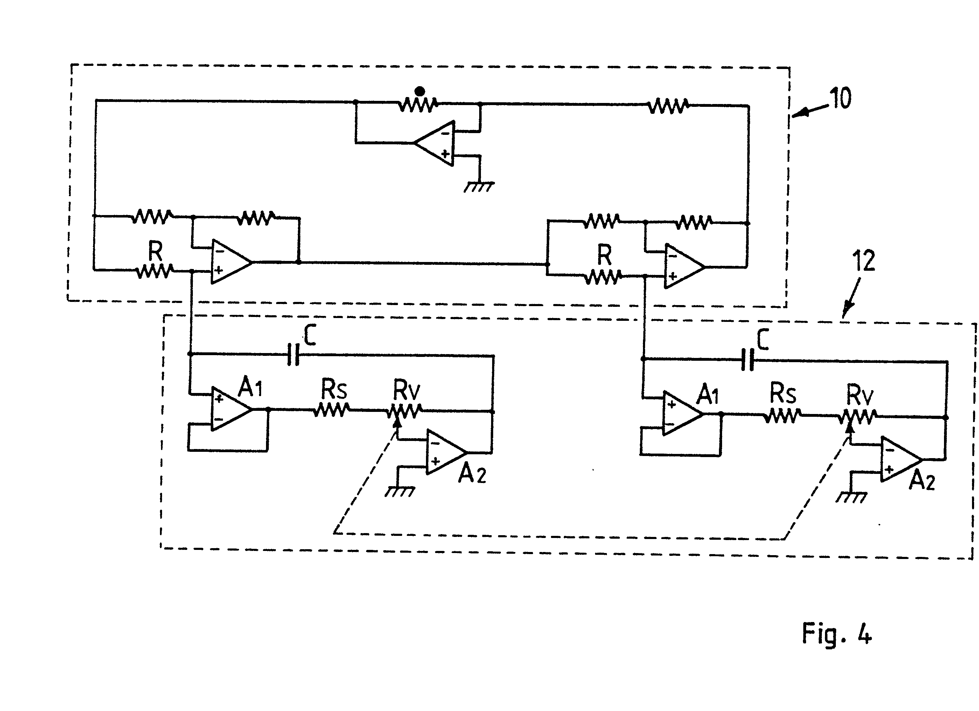

Referring to Figure 4, the circuitry within the dashed lines referenced 10 is essentially that of the known audio signal generator of Figure 1, with the exception of the ganged capacitors C connected in the circuit of Figure 1 to the non-inverting inputs of the respective operational amplifiers.

The circuitry within the dashed lines referenced 12 comprises two capacitance multiplying circuits, each in accordance with that shown in Figure 3.

This circuit of Figure 3 differs from the known capacitance multiplying circuit of Figure 2 in that the resistors $R_1$, $R_2$ of Figure 2 are replaced by a potentiometer $R_v$, and the inverting input of the operational amplifier $A_2$ is connected to the potentiometer tapping (slider). The circuit of Figure 3 has the property that the effective capacitance $C_{in}$ is inversely proportional to the angular position of the slider of the potentiometer $R_v$ and is independent of the absolute value of the latter.

Thus, reverting to Figure 4, the circuitry 12 provides an R.C. oscillator (audio signal generator) having a linear scale on which the frequency is independent of the absolute value of the control device operating the ganged potentiometers $R_v$.

In the circuit of Figure 4, the resistors $R_s$ may be of the presettable type, included to limit the range of frequency variation imparted by $R_v$ to, for example, one decade, and/or to limit the voltage excursion in the operational amplifiers $A_2$. Either the capacitors C or the resistors R or a combination of both may be switchable to provide multiple frequency ranges.

Possible modifications include omission of the second operational amplifiers $A_1$ and the inclusion of a resistor between the potentiometer $R_v$ and the output of the first operational amplifier $A_2$. These modifications make it possible to avoid the use of special values for the timing resistors or capacitors.

- 6 -

## Claims

1. An audio signal generator of the type normaly including at least one variable frequency oscillator providing for frequency variation by variation of the resistance or the capacitance in an R.C. circuit, wherein the capacitance of said R.C. circuit is replaced by a capacitance multiplying circuit which, in order to provide for the generation of variable frequency signals, includes an amplifier having an input connected to the tapping of a variable resistance connected in parallel with the basic capacitance or conductance of the multiplying circuit.

2. An audio signal generator according to claim 1, including at least two said multiplying circuits, and the variable resistances thereof are ganged together.

3. An audio signal generator according to claim 1 or claim 2, wherein the or each multiplying circuit comprises the basic capacitance, the variable resistance connected in parallel therewith, an operational amplifier having an earthed input and an input connected to the tapping of the variable resistance, and an output connected to the junction on the output side between the basic capacitance and the parallel circuit path containing the variable resistance.

4. An audio signal generator according to claim 3, including a second operational amplifier connected in the parallel circuit path on the input side of the variable resistance.

5. An audio signal generator according to claim 4, wherein the second operational amplifier has unity gain.

6. An audio signal generator according to claim 4, wherein the second operational amplifier has a predetermined gain selected in dependence on the value of the basic capacitance of the multiplying circuit.

7. An audio signal generator according to any of claims 3 to 6, including a resistance of predetermined fixed value connected in the output of the first mentioned operational amplifier.

8. An audio signal generator according to any of claims 4 to 6, including a resistor connected in series between the second operational amplifier an the variable resistance.

9. An audio signal generator according to any of claims 3 to 8, including switchable capacitors and/or resistors for providing multiple frequency ranges.

10. An audio signal generator substantially as hereinbefore described with reference to Figure 4 of the accompanying drawings.

PRIOR ART

Fig.1

$C_{in} \rightarrow$

PRIOR ART

Fig. 2

$C_{in} \rightarrow$

Fig.3

0174710

Fig. 4

European Patent
Office

**EUROPEAN SEARCH REPORT**

0174710
Application number

EP 85 30 3243

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | US-A-3 396 346 (P.L. RICHMAN) * figure 4; column 2, lines 20-41 * | 1-3 | H 03 B 5/20 |
| A | INTERNATIONAL J. ELECTRONICS, vol. 44, no. 1, 1978, pages 65-78; R. NANDI "New RC oscillators with single-element controls" * page 74, figure 15, lines 15-21, table 4 * | 1 | |
| A | INTERNATIONAL J. ELECTRONICS, vol. 38, no. 5, 1975, pages 691-692; A.K. BANDYOPADHYAY "A variable frequency oscillator" * page 691, figure * | 1 | |
| A | ELEKTRONIK, no. 9, 1971, pages 307-310; O. LIMANN "RC-Glieder für Frequenzgeneratoren" * page 309, images 9, 10 * | 9 | TECHNICAL FIELDS SEARCHED (Int Cl 4) <br><br> H 03 B 5/20 <br> H 03 B 5/24 <br> H 03 B 5/26 |

The present search report has been drawn up for all claims

| Place of search | Date of completion of the search | Examiner |
|---|---|---|
| BERLIN | 24-10-1985 | BREUSING J |